# EUROPÄISCHE PATENTSCHRIFT

(11) **EP 4 171 960 B1**
(45) Veröffentlichungstag und Bekanntmachung des Hinweises auf die Patenterteilung: **18.09.2024**
(21) Anmeldenummer: 21737432.1
(22) Anmeldetag: 29.06.2021
(51) Int. Cl.: B41F 15/08, B41F 15/40, B41F 15/36, B41F 15/44, H05K 3/12

(54) **DRUCKVORRICHTUNG UND DRUCKSYSTEM MIT SCHABLONENMAGAZIN ZUM BEDRUCKEN FLÄCHIGER SUBSTRATE**
PRINTING MACHINE AND PRINTING SYSTEM HAVING SCREEN MAGAZINE FOR PRINTING ON PLANAR SUBSTRATES
MACHINE D'IMPRESSION ET SYSTÈME D'IMPRESSION AYANT UN MAGASIN D'ÉCRANS POUR IMPRESSION SUR DES SUBSTRATS PLANS

(30) Priorität: 30.06.2020 DE 102020208163
(43) Veröffentlichungstag der Anmeldung: 03.05.2023
(73) Patentinhaber: Ekra Automatisierungssysteme GmbH, 74357 Bönnigheim (DE)
(72) Erfinder: SZEKERESCH, Jakob, 75328 Schömberg (DE); HAMMANN, Michael, 75038 Oberderdingen (DE); VEGELAHN, Torsten, 75447 Sternenfels (DE); KREIBL, Werner, 88662 Überlingen (DE)
(74) Vertreter: Clarenbach, Carl-Philipp
(86) Internationale Anmeldenummer: PCT/EP2021/067812
(87) Internationale Veröffentlichungsnummer: WO 2022/002915

(56) Entgegenhaltungen:
- WO-A1-2019/244265
- JP-A- H04 197 684
- JP-A- H07 314 639

## Beschreibung

Die Erfindung betrifft eine Druckvorrichtung zum Bedrucken flächiger Substrate, insbesondere Leiterplatten, mit einem sich in einer horizontalen Ebene erstreckenden Drucktisch, auf welchem zumindest ein zu bedruckendes Substrat anordenbar ist, mit zumindest einer dem Drucktisch zugeordneten Druckeinrichtung, die eine Schablonenaufnahme für eine austauschbare Druckschablone und eine der Schablonenaufnahme zugeordnete Rakeleinrichtung aufweist, mittels welcher eine Druckmasse durch eine Druckschablone auf das zu bedruckende Substrat aufbringbar ist, und mit einem der Rakeleinrichtung zugeordneten Schablonenmagazin zur Aufbewahrung von zumindest einer Druckschablone für die Druckeinrichtung.

Ferner betrifft die Erfindung ein Drucksystem mit einer wie obenstehend beschrieben ausgebildeten Druckvorrichtung.

Druckvorrichtungen und Drucksysteme der eingangs genannten Art sind aus dem Stand der Technik bekannt. Zum Bedrucken flächiger Substrate mit einer Druckmasse, insbesondere einer Druckpaste, die beispielsweise elektrisch leitfähig ist, ist es bekannt, die Druckmasse mithilfe einer Rakeleinrichtung und einer Druckschablone auf das zu bedruckende Substrat aufzubringen. Dazu weisen bekannte Druckvorrichtungen einen Drucktisch auf, auf welchem das zu bedruckende Substrat anordenbar und insbesondere arretierbar ist, sowie die bereits genannte Rakeleinrichtung und die Druckschablone, die zwischen Rakeleinrichtung und dem Substrat angeordnet wird. Zunächst wird die Druckmasse auf die von dem Substrat abgewandte Seite der Druckschablone auf die Druckschablone aufgebracht und anschließend mithilfe der Rakeleinrichtung durch die Druckschablone hindurch auf das darunterliegende Substrat gepresst oder gedrückt. Weil mit jeder Druckschablone nur ein Druckmuster auf das Substrat aufbringbar ist, muss für jedes gewünschte Druckbild eine eigene Druckschablone hergestellt und bereitgehalten werden. Insbesondere bei Substraten, die mit unterschiedlichen Druckmassen entlang unterschiedlicher Strukturen bedruckt werden sollen, ist auch beim Bedrucken eines einzelnen Substrats der Austausch einer Druckschablone notwendig, wenn nicht für jeden Druckvorgang eine eigene Druckvorrichtung vorgehalten werden soll. Daher wurden in der Vergangenheit bereits Schablonenmagazine entwickelt, die zur Aufbewahrung mehrerer Druckschablonen dienen und der Rakeleinrichtung zum Austausch von Druckschablonen zugeordnet sind. So sind mittlerweile auch Wechseleinrichtungen bekannt, die vollautomatisiert einen Austausch von einer Druckschablone der Druckvorrichtung mit einer in einem Schablonenmagazin vorgehaltenen Druckschablone durchführen. Bekannte Schablonenmagazine sind dabei neben der Druckvorrichtung eigenständig angeordnet und sind dazu ausgebildet, eine Vielzahl von Druckschablonen aufzunehmen. Druckvorrichtungen mit derartigen Schablonenmagazinen benötigen viel Bauraum, der insbesondere in Fertigungslinien häufig selten vorhanden ist.

Aus der Offenlegungsschrift JP H07 314639 A ist bereits eine Druckvorrichtung der eingangs genannten Art bekannt. Weitere Druckvorrichtungen sind aus den Offenlegungsschriften JP H04 197684 A und WO 2019/244265 A1 bekannt.

Der Erfindung liegt daher die Aufgabe zugrunde, eine verbesserte Druckvorrichtung zu schaffen, die trotz des Vorhandenseins eines Schablonenmagazins wenig Bauraum beansprucht und einen vorteilhaften Austausch von Druckschablonen ermöglicht.

Die der Erfindung zugrundeliegende Aufgabe wird durch eine Druckvorrichtung mit den Merkmalen des Anspruchs 1 gelöst. Diese hat den Vorteil, dass das Schablonenmagazin nur dann viel Bauraum benötigt, wenn ein Schablonenaustausch stattfindet, und ansonsten bauraumsparend an der Druckvorrichtung angeordnet ist. Hierdurch ist beispielsweise ermöglicht, dass die Druckvorrichtung derart in einer Fertigungslinie angeordnet ist, dass das Schablonenmagazin für die Durchführung eines Austauschvorgangs in einen an der Druckvorrichtung vorbeiführenden Weg für Personen oder Bediener angeordnet wird und ansonsten den Weg freigibt. Dadurch wird eine vorteilhafte Ausnutzung des vorhandenen Bauraums beispielsweise in einer Fertigungshalle oder dergleichen gewährleistet. Erfindungsgemäß wird dies dadurch erreicht, dass das Schablonenmagazin ein Gehäuse mit zumindest zwei parallel zueinander angeordneten Schubfächern aufweist, die jeweils zur Aufnahme einer Druckschablone ausgebildet sind, wobei das Gehäuse derart verschwenkbar zu der Rakeleinrichtung angeordnet ist, dass es zwischen einer ersten Stellung, in welcher die Schubfächer übereinander parallel zu der horizontalen Ebene ausgerichtet sind, und einer zweiten Endstellung, in welcher die Schubfächer in einem Winkel, insbesondere in einem rechten Winkel, zu der horizontalen Ebene ausgerichtet sind, verschwenkbar ist. Das Schablonenmagazin ist somit zwischen einer horizontalen und einer dazu geneigten Ausrichtung verschwenkbar gelagert. In der horizontalen Ausrichtung erstreckt sich das Gehäuse beziehungsweise das Schablonenmagazin weit in den Raum neben der Druckvorrichtung hinein, während es in der vertikalen Ausrichtung an der Druckvorrichtung im Wesentlichen anliegt und dadurch nur wenig Bauraum neben der Druckvorrichtung beansprucht. Durch die Verschwenkbarkeit des Schablonenmagazins wird somit nur eine zeitweise Bauraumbeanspruchung erreicht, die dazu führt, dass die Druckvorrichtung auch an Stellen angeordnet werden kann, an welchen zumindest zeitweise ein ausreichend breiter Durchgang an der Vorrichtung vorbei vorhanden sein muss, um beispielsweise Personal oder autonom fahrende Fahrzeuge passieren zu lassen. Damit gewährleistet ist, dass der Bauraum in vorteilhafter Weise freigegeben wird, wenn kein Austausch einer Schablone stattfindet, weist das Gehäuse vorzugsweise eine Höhe auf, die deutlich kleiner als die Länge des Gehäuses ist. Unter der Länge des Gehäuses wird dabei die (horizontale) Längserstreckung des Gehäuses in der ersten Endstellung verstanden und entsprechend wird als Höhe des Gehäuses die (vertikale) Höhe des Gehäuses in der ersten Endstellung verstanden. Vorzugsweise weist dazu das Schablonenmagazin eine begrenzte Anzahl von Schubfächern auf, wie beispielsweise maximal vier oder weniger, bevorzugt nur zwei. Das Schablonenmagazin ist insbesondere dauerhaft/fest oder austauschbar/lösbar in die Druckvorrichtung integriert beziehungsweise integrierbar.

Gemäß einer bevorzugten Weiterbildung der Erfindung ist das Gehäuse mit den Schubfächern in der zweiten Endstellung zumindest im Wesentlichen vertikal ausgerichtet. Dadurch ergibt sich eine besonders geringe Bauraumbeanspruchung, in dem Moment, in welchem ein Austausch einer Druckschablone nicht erfolgt beziehungsweise in der Zeit, in welcher ein Druckvorgang durch die Druckvorrichtung mittels einer Druckschablone vorgenommen wird. Das Gehäuse wird dazu insbesondere um 90° aus der horizontalen in die vertikale Endstellung oder andersherum verschwenkt.

Gemäß einer bevorzugten Weiterbildung der Erfindung ist das Gehäuse zumindest in der ersten Endstellung höhenverstellbar zu der Schablonenaufnahme gelagert. Durch die Höhenverstellung des Gehäuses wird erreicht, dass die in dem Gehäuse angeordneten und in den Schubfächern gehaltenen Druckschablonen in der Höhe verfahrbar sind. Hierdurch wird beispielsweise erreicht, dass stets die Druckschablone durch eine Höhenverstellung des Gehäuses auf Höhe der Schablonenaufnahme angeordnet wird, die für einen Druck zu verwenden ist. Dadurch kann das Ausfahren der jeweiligen Schablone aus dem Gehäuse in Bezug auf die Schablonenaufnahme stets auf gleicher Höhe erfolgen, wodurch eine einfache Mechanik oder Kinematik zum Durchführen des eigentlichen Austauschvorgangs notwendig ist. Gemäß einer weiteren Ausführungsform der Erfindung ist das Gehäuse um bis zu 180° verschwenkbar, sodass es beispielsweise in einer Verstauposition unterhalb des Drucktischs die zweite Endstellung erreicht, wodurch eine maximale Bauraumeinsparung neben der Druckvorrichtung gewährleistet ist. Gemäß einer weiteren Ausführungsform der Erfindung sind die Schubfächer zusätzlich oder alternativ in dem Gehäuse höhenverstellbar, sodass sie innerhalb des Gehäuses in der Höhe verfahren werden können, ohne dass stets die einzuschiebende oder auszuschiebende Druckschablone auf der gewünschten Höhe bezogen auf die Rakeleinrichtung beziehungsweise die Schablonenaufnahme liegt.

Weiterhin ist bevorzugt vorgesehen, dass die Druckvorrichtung eine Einrichtung aufweist, die dazu ausgebildet ist, eine Druckschablone in eines der Schubfächer einzuschieben und aus einem der Schubfächer heraus in die Schablonenaufnahme zu ziehen. Die Einrichtung dient also dem Austausch von Druckschablonen. Damit wird der Austauschvorgang insbesondere vollautomatisch durch die Druckvorrichtung selbst durchgeführt.

Besonders bevorzugt ist die Einrichtung als magnetisch arbeitende Greifeinrichtung ausgebildet. Dabei sind die Druckschablonen vorzugsweise selbst magnetisierbar oder magnetisch, um mit der Greifeinrichtung zusammenzuwirken. Durch die magnetische Ausbildung kann auf eine formschlüssige Verbindung von Einrichtung und Druckschablone verzichtet werden, wodurch die Druckschablone kostengünstig und selbst bauraumsparend realisierbar sind.

Besonders bevorzugt ist die Einrichtung separat zu der Rakeleinrichtung ausgebildet. Das bedeutet, dass die Einrichtung eine eigene Aktorik zum Bewegen der jeweiligen Druckschablone von dem Schablonenmagazin zu der Rakeleinrichtung und zurück aufweist.

Gemäß einer alternativen Ausführungsform der Erfindung ist die Einrichtung durch die Rakeleinrichtung selbst gebildet. Dies bedeutet, dass die Rakeleinrichtung auch dazu geeignet ist, eine der Druckschablonen in das Schablonenmagazin einzuschieben und beispielsweise eine andere Druckschablone aus dem Schablonenmagazin herauszuziehen und in der Schablonenaufnahme zu platzieren. Üblicherweise weist die Rakeleinrichtung einen sich quer über den Drucktisch erstreckenden Träger oder Schlitten auf, der randseitig auf Schienen geführt und durch einen Antrieb verfahrbar ist. Dadurch ist die einfache Positionierung der Rakeleinrichtung beziehungsweise eines Rakels der Rakeleinrichtung ermöglicht. So ist beispielsweise vorgesehen, dass eine Rakelaufnahme zur Aufnahme eines Rakels durch die Rakeleinrichtung oberhalb des Drucktischs verfahrbar ist und als Greifeinrichtung zum Verschieben einer Druckschablone genutzt wird. Beispielsweise ist dazu die Rakelaufnahme magnetisierbar ausgebildet, um bei Bedarf eine der Druckschablonen zu verschieben. Besonders bevorzugt ist dabei die Rakelaufnahme auch in der Höhe verfahrbar, insbesondere um eine Druckschablone zu greifen oder freizugeben.

Gemäß einer weiteren Ausführungsform der Erfindung ist die Einrichtung bevorzugt durch eine über dem Drucktisch bewegbare Kameraeinrichtung mitgebildet. Bekannte Druckvorrichtungen weisen eine Kameraeinrichtung auf, die beispielsweise dazu genutzt wird, die korrekte Ausrichtung und/oder Position eines Substrats auf dem Drucktisch oder einer einzusetzenden Druckschablone an der Rakeleinrichtung zu überprüfen. Dazu wird eine Kamera über den Drucktisch gefahren, mittels welcher das Substrat und/oder die Druckschablone optisch erfasst werden. Durch Bildauswertung wird dann festgestellt, ob Druckschablone und Substrat optimal zueinander ausgerichtet sind. Werden Abweichungen festgestellt, so wird beispielsweise die Druckschablone oder das Substrat auf dem Drucktisch verschoben, bis die gewünschte Positionierung zueinander erreicht ist. Da derartige Kameraeinrichtungen eine in X-Y-Ebene verfahrbare Kamera umfasst, kann die zum Bewegen der Kamera bereits vorhandene Aktuatorik dazu genutzt werden, eine Druckschablone zu greifen und in das Gehäuse einzuschieben und aus diesem herauszuziehen. Optional weist dazu die Kameraeinrichtung einen mechanischen Greifer oder Stößel auf, oder einen magnetischen oder magnetisierbaren Greifer, mittels dessen die jeweilige Druckschablone greifbar und verschiebbar ist.

Besonders bevorzugt sind der Drucktisch, die Rakeleinrichtung und das Schablonenmagazin an einem Rahmengestell angeordnet beziehungsweise gehalten. Durch das Rahmengestell ist eine vorteilhafte Anordnung von Drucktisch, Rakeleinrichtung und Schablonenmagazin zueinander gewährleistet.

Weiterhin ist bevorzugt vorgesehen, dass das Gehäuse an dem Rahmengestell verschwenkbar gelagert ist. Dadurch ist das Gehäuse einfach der Rakeleinrichtung zugeordnet und mechanisch mit dieser verbunden. Hierdurch ist eine robuste Anordnung des Schablonenmagazins an der Druckvorrichtung gewährleistet.

Vorzugsweise ist das Gehäuse des Schablonenmagazins an dem Rahmengestell in der Höhe verschiebbar gelagert, sodass die oben genannten Vorteile zur Höhenverstellung erzielt werden.

Besonders bevorzugt ist das Gehäuse durch ein linear verschiebbares Drehgelenk an dem Drucktisch gelagert. Durch das Drehgelenk ist das Verschwenken des Gehäuses ermöglicht und durch die lineare Verschiebbarkeit die Höheneinstellung.

Vorzugsweise ist dem Gehäuse zumindest ein ansteuerbarer Aktuator zum Verlagern des Gehäuses, insbesondere zum Verschwenken und/oder Verschieben des Gehäuses beziehungsweise des Schablonenmagazins zugeordnet. Dadurch ist eine automatisierte Verstellung des Gehäuses in die erste oder zweite Endstellung sowie eine Höhenanpassung automatisiert durchführbar.

Besonders bevorzugt ist der Aktuator als Elektro-, Hydraulik- oder Pneumatikaktuator ausgebildet. Weiterhin ist bevorzugt vorgesehen, dass dem Gehäuse eine lösbare Halteeinrichtung zugeordnet ist, die dazu ausgebildet ist, das Gehäuse in der ersten Endstellung formschlüssig zu arretieren. Dadurch wird Energie zum Halten des Gehäuses in der ersten Endstellung gespart, da beispielsweise der Aktuator nicht dauerhaft das Gehäuse entgegen der Schwerkraft in der ersten Endstellung halten muss. Durch die lösbare Halteeinrichtung ist vielmehr eine formschlüssige Arretierung, beispielsweise Verrastung, insbesondere an dem Rahmengestell, gewährleistet.

Vorzugsweise ist das Gehäuse zur Aufnahme unterschiedlich großer Druckschablonen ausgebildet. Dazu sind die Schubfächer beispielsweise unterschiedlich ausgebildet oder derart ausgebildet, dass unterschiedlich große Druckschablonen in den Schubfächern platziert werden können.

Besonders bevorzug ist das jeweilige Schubfach dazu ausgebildet, die jeweilige Druckschablone und ein Rakelwerkzeug für die Rakeleinrichtung aufzunehmen. Hierdurch wird erreicht, dass eine Druckschablone zusammen mit dem Rakelwerkzeug, insbesondere dem Rakel, in dem Gehäuse anordenbar ist. Das Mitführen des Rakels mit der Druckschablone hat den Vorteil, dass eine einfache Umrüstung der Rakeleinrichtung auf unterschiedliche Druckmassen oder Druckmassenarten möglich ist, da das Rakel mit der Druckschablone zusammenbleibt und mit ausgetauscht wird. Dadurch kann auf eine Reinigung des Rakels zum Durchführen eines weiteren Druckvorgangs mit einer dann anderen Druckmasse verzichtet werden. Hierdurch wird die Umrüstzeit der Druckvorrichtung weiter verkürzt. Insbesondere weist die jeweilige Druckschablone eine Aufnahme für zumindest ein Rakel auf, sodass das Rakel mit der jeweiligen Druckschablone mitführbar ist.

Besonders bevorzugt ist das Schablonenmagazin lösbar beziehungsweise austauschbar an dem Rahmengestell oder der Rakeleinrichutng angeordnet. Dadurch ist beispielsweise auch ein Austausch des gesamten Schablonenmagazins beziehungsweise Schablonenmagazins einfach durchführbar. So kann das Schablonenmagazin entfernt von der Druckvorrichtung bestückt und vorbereitet und anschließend der Druckvorrichtung zugefügt, beispielsweise an dem Rahmengestell arretiert und mit dem zumindest einen Aktuator verbunden oder gekoppelt werden. Besonders bevorzugt ist das Schablonenmagazin dazu ausgebildet, von einem Roboter, insbesondere Flurförderwerkzeug, von der übrigen Druckvorrichtung gelöst oder entfernt und beispielsweise für eine Bestückung mit Druckschablonen oder für einen Austausch der in dem Schablonenmagazin gelagerten Druckschablonen zu einem Bestückungsautomaten bewegt zu werden. Gemäß einer alternativen Ausführungsform der Erfindung ist das Schablonenmagazin bevorzugt dauerhaft oder fest an dem Rahmengestell oder der Rakeleinrichtung angeordnet, wodurch eine besonders robuste Verbindung zu dem Rahmengestell oder der Rakeleinrichtung realisierbar ist.

Gemäß einer bevorzugten Weiterbildung der Erfindung weist das Schablonenmagazin eine Vorrichtung zum Ausschieben und/oder Einziehen von Druckschablonen aus und/oder in eines der Schubfächer auf. Bei der Vorrichtung handelt es sich beispielsweise um einen Schieber, der auf dem von der Rakeleinrichtung abgewandten Ende des Gehäuses angeordnet ist, um eine Druckschablone bei Bedarf zumindest bereichsweise aus dem Gehäuse rauszuschieben, sodass diese durch die Einrichtung zum Verschieben beziehungsweise zum Austauschen der Druckschablonen einfacher zu greifen ist.

Weiterhin betrifft die Erfindung ein Drucksystem zum Bedrucken flächiger Substrate, das eine Druckvorrichtung aufweist, die wie vorstehend beschrieben ausgebildet ist.

Das erfindungsgemäße Drucksystem mit den Merkmalen des Anspruchs 18 zeichnet sich dadurch aus, dass es zumindest eine Druckschablone aufweist, die dazu ausgebildet ist, in einem der Schubfächer des Schablonenmagazins aufgenommen zu werden. Dazu weist die Druckschablone beispielsweise eine Außenkontur auf, die zu den Abmaßen des jeweiligen Schubfachs korrespondieren.

Besonders bevorzugt ist die Druckschablone zur Aufnahme zumindest eines Rakelwerkzeugs, insbesondere Rakel, ausgebildet und das jeweilige Schubfach des Schablonenmagazins zur Aufnahme der Druckschablone zusammen mit dem zumindest einen Rakelwerkzeug. Es ergeben sich hierdurch die oben bereits genannten Vorteile.

Im Folgenden soll die Erfindung anhand der Zeichnungen näher erläutert werden. Dazu zeigen
- Figur 1: eine vorteilhafte Druckvorrichtung in einer perspektivischen Darstellung,
- Figuren 2A und 2B: die Druckvorrichtung in unterschiedlichen Betriebszuständen, jeweils in einer Seitenansicht und
- Figur 3: eine perspektivische Detailansicht der Druckvorrichtung.

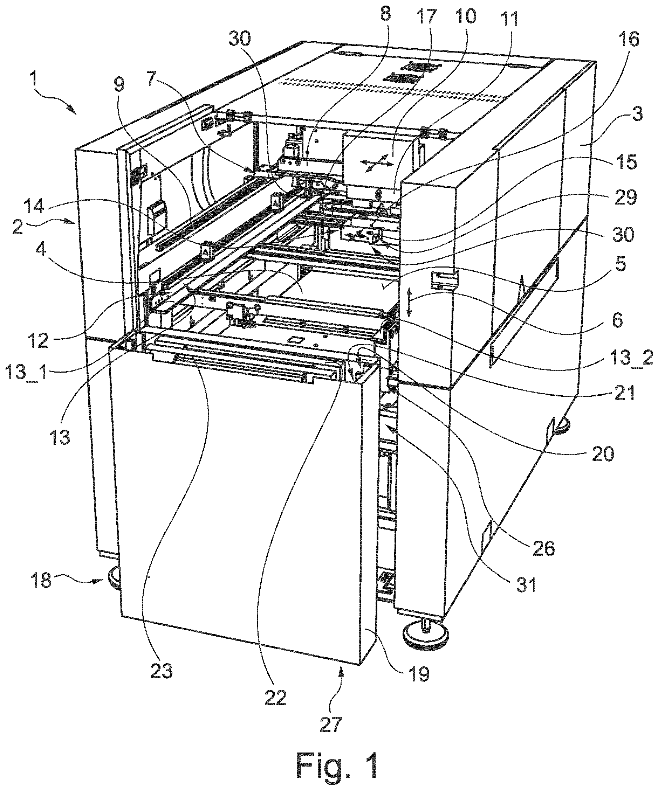

**Figur 1** zeigt in einer perspektivischen Darstellung eine vorteilhafte Druckvorrichtung 1, die dazu ausgebildet ist, flächige Substrate mit einer insbesondere elektrisch leitfähigen Druckmasse oder -paste zu bedrucken, um beispielsweise Leiterplatten herzustellen. Die Druckvorrichtung 1 weist dazu ein Rahmengestell 2 auf, das ein Gehäuse 3 trägt, welches die im Inneren des Gehäuses 3 liegenden Komponenten der Druckvorrichtung 1 vor äußeren Einflüssen schützt. In dem Gehäuse 3 ist ein Drucktisch 4 angeordnet, der eine sich horizontal erstreckende Auflagefläche 5 zum Auflegen eines oder mehrerer zu bedruckender Substraten aufweist. Vorzugsweise ist der Drucktisch 4 in der Höhe verfahrbar, wie durch einen Doppelpfeil 6 gezeigt, um eine optimale Höhenposition eines zu bedruckenden Substrats zu gewährleisten. Oberhalb des Drucktischs 4, also der Auflagefläche 5 gegenüberliegend, weist die Druckvorrichtung 1 außerdem eine Rakeleinrichtung 7 auf. Die Rakeleinrichtung 7 weist einen ersten Schlitten 8 auf, der entlang einer sich horizontal erstreckenden Schienenführung 9 über dem Drucktisch 4 verschiebbar ist, sowie einen zweiten Schlitten 10, der an dem ersten Schlitten 8 quer zur Schieberichtung der Schienenführung 9 verschiebbar gelagert ist. An dem zweiten Schlitten 10 ist ein Rakelhalter 11 angeordnet, der zur Aufnahme und Betätigung eines Rakelwerkzeugs, insbesondere eines Rakels 36 ausgebildet ist.

Vertikal zwischen dem Drucktisch 4 und den Schlitten 10, 8 ist eine Schablonenaufnahme 12 angeordnet. Die Schablonenaufnahme 12 weist vorteilhafterweise eine Schienenführung 13 in der Art eines Schubfachs auf, die sich parallel zu der Schienenführung 9 erstreckt und ebenso wie die Schienenführung 9 beidseits des Drucktischs 4 parallel zueinander angeordnete Führungsschienen 13_1, 13_2, beispielsweise Sieb- bzw. Schablonenauflageleisten, aufweist. Die Schienenführung 13 ist dazu ausgebildet, eine Druckschablone randseitig zu führen und zu tragen, sodass eine Druckmasse auf die Druckschablone aufbringbar und mittels eines an dem Rakelhalter 11 angeordneten Rakels durch die Druckschablone hindurch auf ein auf den Drucktisch 4 aufliegendes Substrat druckbar ist.

Weiterhin weist die Druckvorrichtung 1 eine Kameraeinrichtung 14 auf, die eine Kamera 15 aufweist, welche vertikal zwischen der Rakeleinrichtung 7 und dem Drucktisch 4 verfahrbar angeordnet ist. Dazu ist die Kamera 15 wie auch der Rakelhalter 11 an einem Schlitten 16 gehalten, der längsverschieblich auf einem Schlitten 17 gelagert ist, wobei der Schlitten 17 längsverschieblich parallel der Schienenführung 9 der Rakeleinrichtung 7 oberhalb des Drucktischs 4 und unterhalb der Rakeleinrichtung 7 verschiebbar ist. Dadurch kann die Kamera 15 über den gesamten Drucktisch 4 bewegt werden. Die Kamera 15 ist dabei vorzugsweise derart angeordnet oder ausgebildet, dass sie dem Drucktisch 4 und/oder der Rakeleinrichtung 7, insbesondere der Schablonenaufnahme 12 zugeordnet ist, um die Position eines auf dem Drucktisch 4 abgelegten Substrats und/oder die Position einer in der Schienenführung 13 beziehungsweise in der Schablonenaufnahme 12 aufgenommenen Druckschablone zu überprüfen, bevor ein Druckvorgang ausgeführt wird. Wird beispielsweise eine Abweichung einer aktuellen Ist-Position von Drucksubstrat oder Druckschablone zu einer Soll-Position erfasst, so wird entweder eine automatisierte Justierung vorgenommen oder der Bediener der Druckvorrichtung 1 darauf hingewiesen, das Substrat und/oder die Schablone korrekt auszurichten.

Weiterhin weist die Druckvorrichtung 1 ein vorteilhaftes Schablonenmagazin 18 auf, das dazu dient, eine Umrüstung der Druckvorrichtung 1 für den Druckvorgang mit einer anderen als der bisher verwendeten Druckschablone zu vereinfachen, insbesondere zu automatisieren.

Das Schablonenmagazin 18 weist gemäß dem vorliegenden Ausführungsbeispiel in einem Gehäuse 19 zwei parallel zueinander angeordnete Schubfächer 20, 21 auf. Jedes Schubfach 20, 21 dient zur Aufnahme zumindest einer Druckschablone, wobei gemäß dem vorliegenden Ausführungsbeispiel in dem Schubfach 20 eine Druckschablone 22 und in dem Schubfach 21 eine Druckschablone 23 angeordnet ist. Vorzugsweise weisen die Durckschablonen unterschiedliche Druckstrukturen auf.

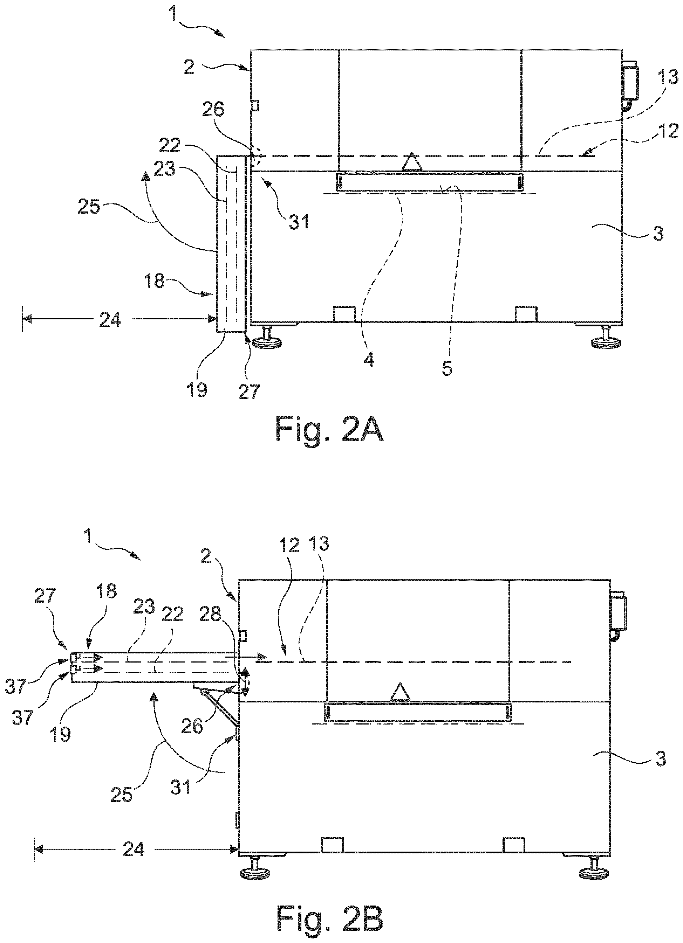

**Figur 2A** zeigt eine Seitenansicht der Druckvorrichtung 1 in dem auch in **Figur 1** gezeigten Zustand. Dabei ist das Schablonenmagazin 18 vertikal ausgerichtet, sodass die darin befindlichen Druckschablonen 22, 23 vertikal nebeneinander stehend angeordnet sind, wie in **Figur 2A** durch gestrichelte Linien angezeigt, und damit in einem Winkel von nahezu oder genau 90° zu der Ebene, entlang welcher sich die Auflagefläche 5 des Drucktischs 4 oder der Schablonenaufnahme 12 erstreckt, wie in **Figur 2A** ebenfalls durch eine gestrichelte Linie angezeigt.

Dadurch, dass in dem Gehäuse 19 nur zwei Schubfächer 20, 21 zur Aufnahme von zwei Druckschablonen 22, 23 ausgebildet sind, steht das Gehäuse 19 von dem Gehäuse 3 der Druckvorrichtung 1 in der vertikalen Endstellung nur geringfügig seitlich ab. Der Raum neben der Druckvorrichtung 1 im Bereich des Schablonenmagazins 18 ist somit für Anderes nutzbar. So handelt es sich beispielsweise bei dem Raum neben der Druckmaschine 1 um einen Flur oder Weg 24 neben einer Fertigungslinie in einer Fertigungshalle.

Das Schablonenmagazin 18 ist insbesondere an dem Rahmengestell 2 verschwenkbar gelagert, sodass es von der in **Figur 2A** gezeigten vertikalen Endstellung in die in **Figur 2B** gezeigte horizontal ausgerichtete Endstellung verschwenkbar ist, wie durch einen Pfeil 25 angezeigt. Dazu ist das Schablonenmagazin 18 durch ein Schwenk- oder Drehgelenk 26 an dem Rahmengestell 2 befestigt. Das Drehgelenk 26 beziehungsweise die durch das Drehgelenk 26 gebildete Drehachse ist dabei zweckmäßigerweise an dem in der vertikalen Ausrichtung oberen Ende des Gehäuses 19 beziehungsweise des Schablonenmagazins 18 angeordnet. Dadurch ist das in **Figur 2A** untenliegende freie Ende 27 des Schablonenmagazins 18 um die Drehachse des Drehgelenks 26 herum verschwenkbar, zumindestens so weit, bis das Schablonenmagazin 18 die horizontale Ausrichtung, wie in **Figur 2B** gezeigt, erreicht. In diesem Zustand liegen dann die in den Schubfächern 20, 21 liegenden Druckschablonen 22, 23 parallel zueinander und horizontal ausgerichtet übereinander, wobei gemäß dem vorliegenden Ausführungsbeispiel die Druckschablone 23 oberhalb der Druckschablone 22 liegt.

In der horizontalen Endstellung, wie in **Figur 2B** gezeigt, liegt zumindest eines der Schubfächer 20, 21 auf Höhe der Schienenführung 13, sodass durch ein einfaches Verschieben der in diesem Schubfach liegenden Druckschablone diese aus dem Gehäuse 19 des Schablonenmagazins 18 auf die Schienenführung 13 der Schablonenaufnahme 12 in die Druckposition verlagerbar ist. In **Figur 2B** ist dazu mit gestrichelter Linie beispielhaft die Schienenführung 13 gezeigt. Damit auch das zweite Schubfach 20 der Schienenführung 13 zuordenbar ist, ist das Drehgelenk 26 bevorzugt in der Höhe an dem Rahmengestell 2 verschiebbar gelagert, wie durch einen Doppelpfeil 28 in **Figur 2B** gezeigt. Durch das Verschieben in der Höhe ist das eine oder das andere Schubfach 20, 21 der Schienenführung 13 zuordenbar und damit die eine oder die andere Druckschablone aus dem Gehäuse 19 herausschiebbar oder in das Gehäuse 19 hineinschiebbar. Alternativ oder zusätzlich ist die Schablonenaufnahme 12 beziehungsweise die Schienenführung 13 mittels eines ansteuerbaren Aktuators in der Höhe gemäß Doppelpfeil 28 verlagerbar oder verschiebbar, um die Schablonenaufnahme 12 und das gewünschte Schubfach 20 oder 21 in eine gemeinsame Ebene zu bewegen.

Gemäß einem vorteilhaften Ausführungsbeispiel der Druckvorrichtung 1 ist an dem Schlitten 16 der Kameraeinrichtung 14 eine Greifeinrichtung 29 angeordnet, wie in **Figur 1** gezeigt, mittels welcher ein Verschieben der Druckschablonen 22, 23 durchführbar ist. Dadurch bildet die Kameraeinrichtung 14 außerdem eine Einrichtung 30 aus, die bei Bedarf eine Druckschablone in eines der Schubfächer 20, 21 einschiebt und aus einem der Schubfächer 20, 21 heraus in die Schablonenaufnahme 12 zieht. Die Greifeinrichtung 29 ist dabei beispielsweise als Transportpin zum mechanischen Hintergreifen und Verschieben einer Druckschablone ausgebildet, oder als magnetischer Greifer, der insbesondere durch Elektrifizierung ein Magnetfeld erzeugt, das mit der jeweiligen Druckschablone 22, 23 zusammenwirkt, um diese verschieben zu können. Dazu sind die Druckschablonen 22, 23 entsprechend aus einem Material gefertigt oder weisen zumindest bereichsweise Material auf, das mit dem magnetischen Greifer zusammenwirkt.

Einen Umrüstvorgang der Druckvorrichtung 1 findet beispielsweise wie folgt statt. Es befindet sich bereits eine Druckschablone, beispielsweise Druckschablone 23, auf den Führungsschienen 13_1,13_2 der Schablonenaufnahme 12 und es wurde bereits ein Druckvorgang mittels dieser Druckschablone 22 ausgeführt. Nur soll ein weiterer Druckvorgang erfolgen, der ein anderes Druckmuster erfordert, sodass ein Austausch der Druckschablone 22 durch die Druckschablone 23 notwendig ist. Zunächst wird die vorhandene Druckschablone 22 durch die Kameraeinrichtung 14 beziehungsweise die Greifeinrichtung 30 entlang der Schienenführung 13 in das freie Schubfach, beispielsweise Schubfach 21, eingeschoben. Dazu wird zuvor das Schablonenmagazin 18 von der vertikalen Endstellung in die horizontale Endstellung, wie in **Figur 2B** gezeigt, verlagert und bei Bedarf in der Höhe verstellt, sodass das Schubfach 20 auf Höhe der Schienenführung 13 liegt. Dadurch ist ein einfaches Einschieben der Druckschablone 22 in das Schablonenmagazin 18 gewährleistet. Anschließend wird das Schablonenmagazin 18 in der Höhe verstellt, sodass das andere Schubfach mit der darin befindlichen Druckschablone 23 auf Höhe der Schienenführung 13 liegt. Nunmehr greift die Greifeinrichtung 30 die der Schienenführung 13 zugeordnete Druckschablone 23 beispielsweise magnetisch und zieht diese aus dem Schubfach 21 heraus auf die Schienenführung bis in die gewünschte Position oberhalb des Drucktischs 4, sodass ein Druckvorgang mittels der Druckschablone 23 durchführbar ist. Die Umrüstung erfolgt dadurch insbesondere vollautomatisiert und in kurzer Zeit. Während des Druckvorgangs oder mehrere Druckvorgänge, bei welchen die gleiche Druckschablone 23 eingesetzt wird, wird das Gehäuse 19 zweckmäßigerweise in die vertikale Endstellung verstellt, wie in Figur 2A gezeigt, sodass der Durchgang des Wegs 24 freigegeben ist. Nur in der horizontal ausgerichteten Endstellung ragt das Gehäuse 19 des Schablonenmagazins 18 in den Weg 24 vor und versperrt diesen gegebenenfalls. Das Schablonenmagazin 18 dient somit als Wechseleinrichtung oder Umrüsteinrichtung für die Druckvorrichtung 1.

In der vertikalen Endstellung, wie in **Figur 2A** und auch in **Figur 1** gezeigt, kann das Schablonenmagazin 18 durch einen Bediener oder automatisiert mit Druckschablonen bestückt werden. Dadurch kann eine Vorbereitung eines Umrüstvorgangs der Druckvorrichtung 1 stattfinden, während ein Druckvorgang ausgeführt wird, und ohne, dass das Schablonenmagazin 18 dabei viel Bauraum neben der Druckvorrichtung 1, insbesondere im Bereich des Wegs 24 verbraucht.

Zum Verlagern und Verschwenken des Schablonenmagazins 18 ist vorzugsweise zumindest ein Aktuator 31 vorhanden, der beispielsweise als elektromotorisch, pneumatisch oder hydraulisch arbeitender Aktuator 31 ausgebildet ist, und das Schablonenmagazin 18 verschwenkt und/oder in der Höhe verstellt. Für letzteres ist beispielsweise das Drehgelenk 26 an einer Schienenführung an dem Rahmengestell 2 verschiebbar gelagert und durch den Aktuator 31 oder einen weiteren Aktuator verschiebbar.

Optional ist das Schablonenmagazin 18 lösbar beziehungsweise austauschbar insbesondere an dem Rahmengestell 2 gehalten, sodass es bei Bedarf von einem Bediener oder einem Roboter, insbesondere ein Flurförderwerkzeug, von der Druckvorrichtung 1 entfernt und beispielsweise zum Bestücken mit weiteren oder anderen Druckschablonen zu einem anderen Ort verbracht werden kann. Alternativ ist das Schablonenmagazin 18 dauerhaft beziehungsweise fest insbesondere an dem Rahmengestell befestigt.

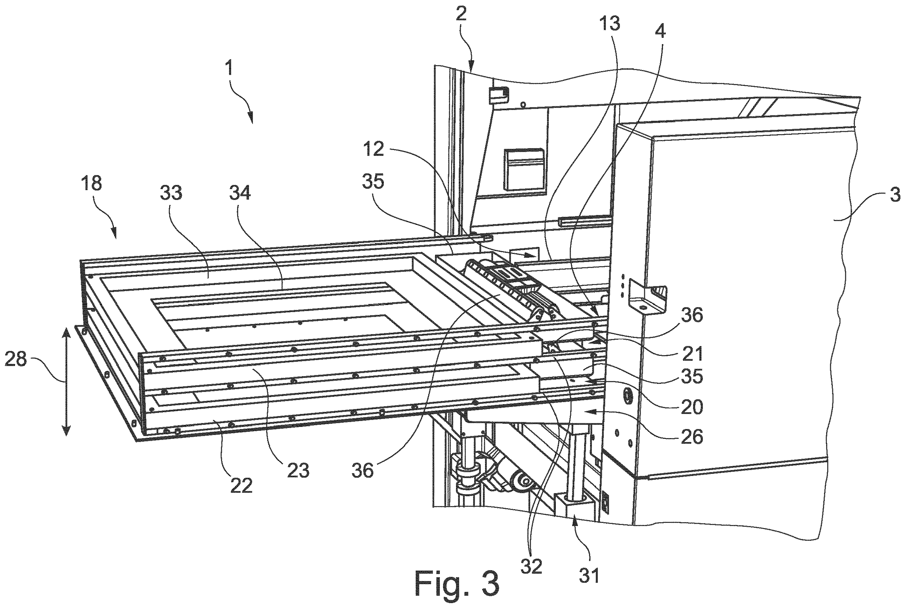

**Figur 3** zeigt in einer weiteren perspektivischen Darstellung eine vergrößerte Detailansicht der Druckvorrichtung 1 im Bereich des Schablonenmagazins 18, wobei das Gehäuse 19 des Schablonenmagazins 18 entfernt wurde, um den Innenaufbau des Schablonenmagazins 18 zu zeigen. Die Schubfächer 20, 21 sind beispielsweise durch seitlich angeordnete Führungsschienen 32 gebildet oder durch plattenförmige Auflagen. Die Schubfächer 20,21 sind dabei ausreichend hoch ausgebildet, um jeweils eine Druckschablone 22, 23 aufzunehmen. In dem in Figur 1 und Figur 3 dargestellten Ausführungsbeispiel sind die Druckschablonen 22, 23 in den Schubfächern 20, 21 angeordnet. Im Unterschied zu **Figur 1** ist in **Figur 3** das Schablonenmagazin 18 in der horizontalen Endstellung gezeigt.

Die jeweilige Druckschablone 22, 23 weist jeweils einen Schablonenrahmen 33 auf, an welchem eine Schablone 34 gehalten, insbesondere eingespannt ist. Bei der Schablone kann es sich um ein Drucksieb oder um eine Druckmaske handeln. An dem jeweiligen Rahmen 33 ist außerdem eine Halteeinrichtung 35 zur Aufnahme eines Rakelwerkzeugs, insbesondere eines Rakels 36 angeordnet. Die Halteeinrichtung 35 ist dabei fest mit dem Rahmen 33 verbunden, sodass ein Rakel 36 mit der jeweiligen Druckschablone 22, 23 mitführbar ist.

Hierdurch wird die Umrüstung der Druckvorrichtung 1 dahingehend verbessert, dass nicht nur eine Druckschablone, sondern auch ein mit der Druckschablone zu verwendenes Rakel automatisiert ausgetauscht beziehungsweise umgerüstet werden kann. Dadurch wird beispielsweise erreicht, dass die Druckschablonen 22, 23 mit unterschiedlichen Druckmassen beaufschlagt und mit unterschiedlichen Rakeln bearbeitet werden können, sodass ein Austauschen und insbesondere Reinigen eines Rakels bei einer Umrüstung der Druckvorrichtung 1 nicht notwendig ist.

Gemäß einem weiteren Ausführungsbeispiel wird die Greifeinrichtung 30 nicht von der Kameraeinrichtung 14, sondern von der Rakeleinrichtung 7 gebildet. Dazu weist beispielsweise der Schlitten 10 den Greifer 15 auf. Alternativ ist der Rakelhalter 11 dazu ausgebildet, das Rakel 36 selbsttätig zu greifen. Sobald er das Rakel 36 einer in dem Schablonenmagazin 18 angeordneten Druckschablone 23 greift, kann er durch Bewegen des Rakels 36 die Druckschablone 23 insgesamt mitbewegen. Dadurch erfolgt ein Umrüsten der Druckschablonen 22, 23 in der Druckvorrichtung 1 durch die Rakeleinrichtung 7, ohne dass zusätzliche Greifeinrichtungen oder dergleichen benötigt werden.

Optional weist das Schablonenmagazin 18 eine dem jeweiligen Schubfach 20, 21 zugeordnete Vorrichtung 37, insbesondere einen Schieber, auf, wie beispielhaft in **Figur 2B** gezeigt, mittels dessen die jeweils in dem Schubfach 20, 21 liegende Druckschablone 22, 23 zumindest bereichsweise aus dem Gehäuse 18 heraus in Richtung der Schablonenaufnahme 12 geschoben werden kann, sodass ein Greifen der jeweiligen Druckschablone 22, 23 durch die Einrichtung 30, insbesondere durch die Rakeleinrichtung 7, vereinfacht wird.

Die Druckvorrichtung 1 bildet zusammen mit den Druckschablonen 22,23, und insbesondere mit weiteren hier nicht dargestellten Druckschablonen, die beispielsweise unterschiedliche Druckmuster aufweisen, und die insbesondere dazu ausgebildet sind, in den Schubfächern 20,21 sowie in der Schablonenaufnahme 12 aufgenommen zu werden, ein vorteilhaftes Drucksystem.

## Patentansprüche

1. Druckvorrichtung (1) zum Bedrucken flächiger Substrate, insbesondere Leiterplatten, mit einem sich in einer horizontalen Ebene erstreckenden Drucktisch (4), auf welchem zumindest ein zu bedruckendes Substrat anordenbar ist, mit zumindest einer dem Drucktisch (4) zugeordneten Druckeinrichtung, die eine Schablonenaufnahme (12) für eine austauschbare Druckschablone (22,23) und eine der Schablonenaufnahme (12) zugeordnete Rakeleinrichtung (7) aufweist, wobei mittels der Rakeleinrichtung (7) eine Druckmasse durch die Druckschablone (22,23) auf das zu bedruckende Substrat aufbringbar ist, und mit einem der Rakeleinrichtung (7) zugeordneten Schablonenmagazin (18) zur Aufbewahrung zumindest einer Druckschablone (22,23) für die Rakeleinrichtung (7), wobei das Schablonenmagazin (18) ein Gehäuse (19) mit zumindest zwei parallel zueinander angeordneten Schubfächern (20,21), die jeweils zur Aufnahme einer Druckschablone (22,23) ausgebildet sind, aufweist, **dadurch gekennzeichnet, dass** das Gehäuse (19) derart verschwenkbar angeordnet ist, dass es zwischen einer ersten Endstellung, in welcher die Schubfächer (20,21) parallel zu der horizontalen Ebene ausgerichtet sind, und einer zweiten Endstellung, in welcher die Schubfächer in einem Winkel zu der horizontalen Ebene, insbesondere vertikal, ausgerichtet sind, verschwenkbar ist.

2. Druckvorrichtung nach Anspruch 1, **dadurch gekennzeichnet, dass** das Gehäuse (19) mit den Schubfächern (20,21) in der zweiten Endstellung zumindest im Wesentlichen vertikal ausgerichtet ist.

3. Druckvorrichtung nach einem der vorhergehenden Ansprüche, **dadurch gekennzeichnet, dass** das Gehäuse (19) zumindest in der ersten Endstellung höhenverstellbar gelagert ist.

4. Druckvorrichtung nach einem der vorhergehenden Ansprüche, **gekennzeichnet durch** eine Einrichtung (30), die dazu ausgebildet ist, eine Druckschablone (22,23) in eines der Schubfächer (20,21) einzuschieben und aus einem der Schubfächer (20,21) herauszuziehen.

5. Druckvorrichtung nach Anspruch 4, **dadurch gekennzeichnet, dass** die Einrichtung (30) eine magnetisch arbeitende Greifeinrichtung aufweist.

6. Druckvorrichtung nach einem der Ansprüche 4 oder 5, **dadurch gekennzeichnet, dass** die Einrichtung (30) separat zu der Rakeleinrichtung (7) ausgebildet ist.

7. Druckvorrichtung nach einem der Ansprüche 4 oder 5, **dadurch gekennzeichnet, dass** die Einrichtung (30) durch die Rakeleinrichtung (7) gebildet ist.

8. Druckvorrichtung nach einem der Ansprüche 4 bis 6, **dadurch gekennzeichnet, dass** die Einrichtung (30) durch eine über den Drucktisch (4) bewegbare Kameraeinrichtung (14) gebildet ist.

9. Druckvorrichtung nach einem der vorhergehenden Ansprüche, **gekennzeichnet durch** ein Rahmengestell (2), an welchem der Drucktisch (4), die Rakeleinrichtung (7) und das Schablonenmagazin (18) angeordnet sind.

10. Druckvorrichtung nach einem der vorhergehenden Ansprüche, **dadurch gekennzeichnet, dass** das Gehäuse (19) in der Höhe verschiebbar an dem Rahmengestell (2) gelagert ist.

11. Druckvorrichtung nach einem der vorhergehenden Ansprüche, **dadurch gekennzeichnet, dass** das Gehäuse (19) durch ein linear verschiebbares Drehgelenk (26) an dem Rahmengestell (2) gelagert ist.

12. Druckvorrichtung nach einem der vorhergehenden Ansprüche, **dadurch gekennzeichnet, dass** dem Gehäuse (18) zumindest ein ansteuerbarer Aktuator (31) zum Verlagern und/oder Verschwenken des Schablonenmagazins (18) zugeordnet ist.

13. Druckvorrichtung nach Anspruch 12, **dadurch gekennzeichnet, dass** der Aktuator (31) als Elektro-, Hydraulik- oder Pneumatikaktuator ausgebildet ist.

14. Druckvorrichtung nach einem der vorhergehenden Ansprüche, **dadurch gekennzeichnet, dass** das Schablonenmagazin (18) zur Aufnahme unterschiedlich großer Druckschablonen (22,23) ausgebildet ist.

15. Druckvorrichtung nach einem der vorhergehenden Ansprüche, **dadurch gekennzeichnet, dass** das jeweilige Schubfach (20,21) dazu ausgebildet ist, die jeweilige Druckschablonen (22,23) und ein der jeweiligen Druckschablone zugeordnetes Rakelwerkzeug, insbesondere Rakel (36) aufzunehmen.

16. Druckvorrichtung nach einem der vorhergehenden Ansprüche, **dadurch gekennzeichnet, dass** das Schablonenmagazin (18) austauschbar an dem Rahmengestell (2) gehalten ist.

17. Druckvorrichtung nach einem der vorhergehenden Ansprüche, **dadurch gekennzeichnet, dass** das Schablonenmagazin (18) eine Vorrichtung zum Ausschieben und Einziehen von Druckschablonen aus und/oder in eines der Schubfächer aufweist.

18. Drucksystem zum Bedrucken flächiger Substrate, mit einer Druckvorrichtung (1) gemäß einem der Ansprüche 1 bis 17, und mit zumindest einer Druckschablone (22,23), die dazu ausgebildet ist, in einem der Schubfächer (20,21) des Schablonenmagazins (18) aufgenommen zu werden.

19. Drucksystem nach Anspruch 18, **dadurch gekennzeichnet, dass** die Druckschablone (22,23) zur Aufnahme eines Rakelwerkzeugs, insbesondere Rakel (36), ausgebildet und das jeweilige Schubfach (20,21) zur Aufnahme der Druckschablone (22,23) zusammen mit dem Rakelwerkzeug ausgebildet ist.

## Claims

1. A printing machine (1) for printing on planar substrates, in particular circuit boards, comprising: a printing table (4) which extends in a horizontal plane and on which at least one substrate to be printed on can be arranged; at least one printing device assigned to the printing table (4), which printing device has a screen holder (12) for an interchangeable printing screen (22, 23) and a doctor device (7) assigned to the screen holder (12), wherein, by means of the doctor device (7), a printing material can be applied onto the substrate to be printed on through the printing screen (22, 23); and a screen magazine (18) assigned to the doctor device (7) for storing at least one printing screen (22, 23) for the doctor device (7), wherein the screen magazine (18) has a housing (19) with at least two drawers (20, 21) which are arranged in parallel to one another and are each designed to hold one printing screen (22, 23), **characterized in that** the housing (19) is pivotably arranged such that it can pivot between a first end position, in which the drawers (20, 21) are oriented parallel to the horizontal plane, and a second end position, in which the drawers are oriented at an angle to the horizontal plane, in particular vertical thereto.

2. The printing machine according to claim 1, **characterized in that** the housing (19) is oriented at least substantially vertically to the drawers (20, 21) in the second end position.

3. The printing machine according to any of the preceding claims, **characterized in that** the housing (19) is mounted to be height-adjustable at least in the first end position.

4. The printing machine according to any of the preceding claims, **characterized by** a device (30) designed to insert a printing screen (22, 23) into one of the drawers (20, 21) and pull it out of the drawers (20, 21).

5. The printing machine according to claim 4, **characterized in that** the device (30) has a magnetically operated gripping device.

6. The printing machine according to one of claims 4 or 5, **characterized in that** the device (30) is designed separately from the doctor device (7).

7. The printing machine according to one of claims 4 or 5, **characterized in that** the device (30) is formed by the doctor device (7).

8. The printing machine according to one of claims 4 to 6, **characterized in that** the device (30) is formed by a camera device (14) movable across the printing table (4).

9. The printing machine according to any of the preceding claims, **characterized by** a frame (2) on which the printing table (4), the doctor device (7) and the screen magazine (18) are arranged.

10. The printing machine according to any of the preceding claims, **characterized in that** the housing (19) is mounted on the frame (2) such that it is displaceable in height.

11. The printing machine according to any of the preceding claims, **characterized in that** the housing (19) is mounted on the frame (2) by a linearly displaceable pivot joint (26).

12. The printing machine according to any of the preceding claims, **characterized in that** at least one controllable actuator (31) for shifting and/or pivoting the screen magazine (18) is assigned to the housing (18).

13. The printing machine according to claim 12, **characterized in that** the actuator (31) is designed as an electric, hydraulic, or pneumatic actuator.

14. The printing machine according to any of the preceding claims, **characterized in that** the screen magazine (18) is designed to hold differently sized printing screens (22, 23).

15. The printing machine according to any of the preceding claims, **characterized in that** the respective drawer (20, 21) is designed to hold the respective printing screens (22, 23) and a doctor tool, in particular a doctor blade (36), assigned to the respective printing screen.

16. The printing machine according to any of the preceding claims, **characterized in that** the screen magazine (18) is retained interchangeably on the frame (2).

17. The printing machine according to any of the preceding claims, **characterized in that** the screen magazine (18) has a means for pushing out and retracting printing screens out of and/or into one of the drawers.

18. A printing system for printing on planar surfaces, comprising: a printing machine (1) according to any one of claims 1 to 17; and at least one printing screen (22, 23) designed to be held in one of the drawers (20, 21) of the screen magazine (18).

19. The printing system according to claim 18, **characterized in that** the printing screen (22, 23) is designed to hold a doctor tool, in particular a doctor blade (36), and **in that** the respective drawer (20, 21) is designed to hold the printing screen (22, 23) together with the doctor tool.

## Revendications

1. Machine d'impression (1) pour l'impression de substrats plans, en particulier de circuits imprimés, avec une table d'impression (4) s'étendant dans un plan horizontal, sur laquelle peut être disposé au moins un substrat à imprimer, avec au moins un dispositif d'impression associé à la table d'impression (4), lequel comprend un logement pour pochoirs (12) pour un pochoir d'impression interchangeable (22, 23) et un dispositif de raclage (7) associé au logement pour pochoirs (12), dans laquelle, au moyen du dispositif de raclage (7), une substance d'impression peut être appliquée à travers le pochoir d'impression (22, 23) sur le substrat à imprimer, et avec un magasin à pochoirs (18) associé au dispositif de raclage (7) pour le stockage d'au moins un pochoir d'impression (22, 23) pour le dispositif de raclage (7), dans laquelle le magasin à pochoirs (18) comprend un boîtier (19) ayant au moins deux tiroirs (20, 21) disposés parallèlement l'un à l'autre, lesquels sont conçus respectivement pour la réception d'un pochoir d'impression (22, 23), **caractérisée en ce que** le boîtier (19) est disposé de manière pivotante de telle sorte qu'il puisse pivoter entre une première position d'extrémité, dans laquelle les tiroirs (20, 21) sont orientés parallèlement au plan horizontal, et une deuxième position d'extrémité, dans laquelle les tiroirs sont orientés selon un certain angle par rapport au plan horizontal, en particulier verticalement.

2. Machine d'impression selon la revendication 1, **caractérisée en ce que** le boîtier (19) est orienté de manière au moins sensiblement verticale avec les tiroirs (20, 21) dans la deuxième position d'extrémité.

3. Machine d'impression selon l'une des revendications précédentes, **caractérisée en ce que** le boîtier (19) est monté de manière réglable en hauteur au moins dans la première position d'extrémité.

4. Machine d'impression selon l'une des revendications précédentes, **caractérisée par** un dispositif (30), lequel est conçu pour insérer un pochoir d'impression (22, 23) dans l'un des tiroirs (20, 21) et pour extraire un pochoir d'impression (22, 23) de l'un des tiroirs (20, 21).

5. Machine d'impression selon la revendication 4, **caractérisée en ce que** le dispositif (30) comprend un dispositif de préhension à fonctionnement magnétique.

6. Machine d'impression selon l'une des revendications 4 ou 5, **caractérisée en ce que** le dispositif (30) est conçu comme étant distinct du dispositif de raclage (7).

7. Machine d'impression selon l'une des revendications 4 ou 5, **caractérisée en ce que** le dispositif (30) est formé par le dispositif de raclage (7).

8. Machine d'impression selon l'une des revendications 4 à 6, **caractérisée en ce que** le dispositif (30) est formé par un dispositif de caméra (14) mobile sur la table d'impression (4).

9. Machine d'impression selon l'une des revendications précédentes, **caractérisée par** un châssis de cadre (2), sur lequel sont disposés la table d'impression (4), le dispositif de raclage (7) et le magasin à pochoirs (18).

10. Machine d'impression selon l'une des revendications précédentes, **caractérisée en ce que** le boîtier (19) est monté sur le châssis de cadre (2) de manière coulissante en hauteur.

11. Machine d'impression selon l'une des revendications précédentes, **caractérisée en ce que** le boîtier (19) est monté sur le châssis de cadre (2) par l'intermédiaire d'une articulation rotative (26) coulissante linéairement.

12. Machine d'impression selon l'une des revendications précédentes, **caractérisée en ce que** le boîtier (18) est associé à au moins un actionneur commandable (31) pour le déplacement et/ou le pivotement du magasin à pochoirs (18).

13. Machine d'impression selon la revendication 12, **caractérisée en ce que** l'actionneur (31) est conçu sous la forme d'un actionneur électrique, hydraulique ou pneumatique.

14. Machine d'impression selon l'une des revendications précédentes, **caractérisée en ce que** le magasin à pochoirs (18) est conçu pour la réception de pochoirs d'impression (22, 23) de différentes tailles.

15. Machine d'impression selon l'une des revendications précédentes, **caractérisée en ce que** le tiroir (20, 21) respectif est conçu pour recevoir les pochoirs d'impression (22, 23) respectifs et un outil de raclage, en particulier un racloir (36), associé au pochoir d'impression respectif.

16. Machine d'impression selon l'une des revendications précédentes, **caractérisée en ce que** le magasin à pochoirs (18) est maintenu de manière interchangeable sur le châssis de cadre (2).

17. Machine d'impression selon l'une des revendications précédentes, **caractérisée en ce que** le magasin à pochoirs (18) comprend une machine pour l'extraction de pochoirs d'impression de l'un des tiroirs et l'insertion de pochoirs d'impression dans l'un des tiroirs.

18. Système d'impression pour l'impression de substrats plans, avec une machine d'impression (1) selon l'une des revendications 1 à 17, et avec au moins un pochoir d'impression (22, 23), lequel est conçu pour être reçu dans l'un des tiroirs (20, 21) du magasin à pochoirs (18).

19. Système d'impression selon la revendication 18, **caractérisé en ce que** le pochoir d'impression (22, 23) est conçu pour la réception d'un outil de raclage, en particulier d'un racloir (36), et le tiroir (20, 21) respectif est conçu pour la réception du pochoir d'impression (22, 23) conjointement avec l'outil de raclage.
